# EUROPÄISCHE PATENTANMELDUNG

(11) **EP 3 217 540 A1**
(43) Veröffentlichungstag der Anmeldung: **13.09.2017**
(21) Anmeldenummer: 17157142.5
(22) Anmeldetag: 21.02.2017
(51) Int. Cl.: H02P 29/68, G01K 7/00, G08C 19/00, H02M 7/48

(54) **SCHALTUNGSANORDNUNG UND VERFAHREN ZUR SICHEREN ÜBERTRAGUNG EINES SENSORSIGNALS**

(30) Priorität: 11.03.2016 DE 102016204094
(71) Anmelder: Baumüller Nürnberg GmbH, 90482 Nürnberg (DE)
(72) Erfinder: DIMAS ZEKRI, Magdi, 90478 Nürnberg (DE)
(74) Vertreter: FDST Patentanwälte

(57) **Zusammenfassung**

Die Erfindung betrifft ein Verfahren zur sicheren Übertragung eines Sensorsignals (S) einer Anzahl von resistiven Sensorelementen (4) von einem ersten Schaltkreis (6a) mit einem vergleichsweise hohen Spannungspotential (U_{ZK}) zu einem galvanisch getrennten zweiten Schaltkreis (6b) auf einem vergleichsweise niedrigen Spannungspotential mittels eines Koppelelements (12), wobei die Sensorelemente (4) jeweils ein Messsignal (Mᵤ, Mᵥ, M_{w}) generieren, das mit einem von einem Signalgenerator (16) erzeugten periodischen Schwingungssignal (D) verglichen wird, wobei anhand des Ergebnisses des Vergleichs jeweils ein Ausgangssignal (Aᵤ, Aᵥ, A_{w}) generiert wird, und wobei die Ausgangssignale (Aᵤ, Aᵥ, A_{w}) zu einem Sensorsignal (S) kombiniert werden, welches proportional zu einem elektrischen Widerstand (Rᵤ, Rᵥ, R_{w}) eines der Sensorelemente (4) ist.

## Beschreibung

Die Erfindung betrifft eine Schaltungsanordnung mit einer Anzahl von resistiven Sensorelementen in einem ersten Schaltkreis mit einer vergleichsweise hohen Betriebsspannung und einem hiervon galvanisch getrennten zweiten Schaltkreis mit einer vergleichsweise niedrigen Betriebsspannung. Die Erfindung betrifft weiterhin ein Verfahren zur sicheren Übertragung eines Sensorsignals der Sensorelemente von dem ersten Schaltkreis zu dem zweiten Schaltkreis mittels eines Koppelelements.

Elektromotorisch betriebene Antriebsmaschinen weisen typischerweise einen gesteuerten Elektromotor auf. Zum Beispiel sind hierfür Elektromotoren bekannt, bei denen ein gegenüber einem Stator drehbar gelagerter Rotor durch ein magnetisches Drehfeld angetrieben wird. Hierzu werden Phasenwicklungen des Stators (Statorwicklung) mit einem entsprechenden elektrischen Dreh- oder Motorstrom beaufschlagt, welcher mittels einer (Motor-)Elektronik gesteuert und/oder geregelt wird. Die Motorelektronik weist hierbei allgemein eine Leistungselektronik zur Erzeugung des Drehstroms sowie eine Auswerteelektronik zur Steuerung bzw. Regelung auf.

Zur Erzeugung des Drehstroms weist die Leistungselektronik eine Brückenschaltung auf, welche im Zuge eines (Motor-)Stromrichters (Wechselrichter) eine Gleichspannung eines angeschlossenen (Gleichspannungs-)Zwischenkreises in einen mehrphasigen Drehstrom zum Antrieb des Rotors wandelt. Die Brückenschaltung ist hierbei beispielsweise aus einer der Anzahl der Phasen entsprechenden Anzahl von (IGBT-)Brückenmodulen aufgebaut. Die Leistungselektronik beziehungsweise die Brückenmodule werden hierbei durch einen Controller als (Motor-)Steuereinheit seitens der Auswerteelektronik geregelt, sodass ein möglichst sicherer und zuverlässiger Betrieb des Elektromotors sichergestellt ist.

Insbesondere bei einem Antrieb schwerer Lasten werden vergleichsweise hohe Drehströme benötigt, um ein ausreichendes Drehmoment des Elektromotors zu erzeugen. Dies bedingt eine vergleichsweise hohe (Betriebs-)Spannung im Bereich der Leistungselektronik, die sowohl für den Controller und dessen Bauteile als auch für einen Benutzer gefährlich und schädlich sein können (Hochvolt-Spannung). Die Leistungselektronik und die Auswerteelektronik sind daher typischerweise in zwei voneinander galvanisch getrennten Schaltkreisen angeordnet. Zum Zwecke der Steuerung und/oder Regelung werden Signale zwischen dem hochvoltseitigen Schaltkreis ("heiße Seite") der Leistungselektronik und dem niedervoltseitigen Schaltkreis ("kalte Seite") der Auswerteelektronik mittels Koppelelementen ausgetauscht.

Zur Überwachung des Betriebs sowie zur Erkennung eines Fehlers des Elektromotors sind typischerweise resistive Sensorelemente zur Messung physikalischer Größen, wie beispielsweise der Temperatur, vorgesehen. Die Sensorelemente werden hierbei baulich fest im Bereich der Leistungselektronik, insbesondere im Bereich der (IGBT-)Brückenschaltung oder der Statorwicklungen, montiert. Vorzugsweise ist hierbei jedem IGBT-Brückenmodul ein Sensorelement zur Überwachung zugeordnet.

Mit anderen Worten sind die Sensorelemente im hochvoltseitigen Schaltkreis angeordnet, wobei die Sensorsignale zur Auswertung an den niedervoltseitigen Schaltkreis übertragen werden. Insbesondere hinsichtlich einer Sicherheitsfunktion, bei welcher der Elektromotor beispielsweise im Zuge einer Überhitzung oder einer Überlast der IGBT-Brückenmodule sicher abgeschaltet werden soll, wird hierbei ein Sensorsignal der Sensorelemente benötigt, welches proportional zum kleinsten oder größten Widerstandswert der resistiven Sensorelemente ist. Mit anderen Worten signalisiert der kleinste oder größte Widerstandswert eine Abweichung der überwachten elektrischen Bauteile von einem Normalbetrieb, und ist daher zur Fehlererkennung von größter Bedeutung.

Zu diesem Zwecke ist es beispielsweise denkbar, dass die Messsignale der Sensorelemente hochvoltseitig miteinander verglichen werden, wobei das Messsignal, welches dem größten Widerstandswert entspricht, als Sensorsignal mittels eines analogen Koppelelements an den Controller übertragen wird. Nachteiligerweise ist die Übertragung derartiger analoger Signale vergleichsweise aufwendig und kostenintensiv sowie hinsichtlich der Signalqualität während der Übertragung vergleichsweise ungenau.

Ebenso denkbar ist, dass die Sensorelemente das jeweilige Messsignal einzeln über ein jeweils zugeordnetes Koppelelement übertragen, wobei die Auswertung bezüglich der Maximums- oder Maximalwertbildung innerhalb des niedervoltseitigen Schaltkreises erfolgt. Dies bedeutet, dass eine der Anzahl der Sensorelemente entsprechende Anzahl von Koppelelementen benötigt wird, sodass derartige Lösungsansätze vergleichsweise kosten- und schaltungsintensiv sind.

Des Weiteren ist es möglich, niedervoltseitige Sensorelemente zu verwenden, welche eine Isolierung gegenüber der Hochvolt-Spannung aufweisen. Derartige Isolierungen wirken sich jedoch nachteilig auf die Messgenauigkeit der Sensorelemente aus, und sind daher aus sicherheitstechnischer Sicht im Hinblick auf eine zuverlässige Erkennung eines Überhitzungsfalls nicht geeignet.

Eine weitere Möglichkeit besteht zum Beispiel darin, die Messsignale leistungsseitig mittels eines Mikrocontrollers zu digitalisieren und zur weiteren Auswertung mittels der Koppelelemente an die Auswerteschaltung zu versenden. Aufgrund der Hochvolt-Spannung werden jedoch vergleichsweise kostenintensive Mikrocontroller benötigt, wodurch die Herstellungskosten der Motorelektronik nachteiligerweise erhöht werden.

Der Erfindung liegt die Aufgabe zugrunde, ein besonders geeignetes Verfahren zur Übertragung eines Sensorsignals einer Anzahl von resistiven Sensorelementen von einem ersten Schaltkreis zu einem galvanisch getrennten zweiten Schaltkreis mittels eines Koppelelements anzugeben. Des Weiteren sollen eine hierzu geeignete Schaltungsanordnung und ein Elektromotor mit einer solchen Schaltungsanordnung angegeben werden.

Bezüglich des Verfahrens wird die Aufgabe erfindungsgemäß mit den Merkmalen des Anspruchs 1 gelöst. Hinsichtlich der Schaltungsanordnung wird die genannte Aufgabe mit den Merkmalen des Anspruchs 4 und hinsichtlich eines die Schaltungsanordnung aufweisenden Elektromotors mit den Merkmalen des Anspruchs 12 erfindungsgemäß gelöst. Vorteilhafte Ausgestaltungen und Weiterbildungen sind Gegenstand der jeweiligen Unteransprüche.

Das erfindungsgemäße Verfahren betrifft eine sichere Übertragung eines Sensorsignals einer Anzahl von resistiven Sensorelementen von einem ersten Schaltkreis mit einer Betriebsspannung mit einem vergleichsweise hohen Spannungspotential zu einem galvanisch getrennten zweiten Schaltkreis mit einer Betriebsspannung auf einem vergleichsweise niedrigen Spannungspotential mittels eines Koppelelements. Das Verfahren ist insbesondere für die Überwachung eines Betriebszustands einer Anzahl von Brückenmodulen eines elektromotorischen Antriebs geeignet und eingerichtet.

Die Sensorelemente erfassen im Betrieb jeweils eine physikalische Messgröße, in deren Abhängigkeit mindestens ein Messsignal generiert wird. Diese oder jedes der Messsignale werden jeweils mit einem von einem Signalgenerator erzeugten periodischen Schwingungssignal verglichen, wobei anhand des Ergebnisses des Vergleichs jeweils ein Ausgangssignal erstellt wird. Die Ausgangssignale werden anschließend zu einem Sensorsignal kombiniert, welches proportional zu einem elektrischen Widerstand eines der Sensorelemente ist. Mit anderen Worten ist das Sensorsignal proportional zu dem Messsignal des entsprechenden Sensorelements.

Dadurch ist eine besonders einfache und kostengünstige Informationsübertragung von dem ersten zu dem zweiten Schaltkreis erreicht, indem für die Anzahl von Sensorelementen lediglich ein einzelnes Koppelelement zur Signalübertragung eines gemeinsamen Sensorsignals notwendig ist.

Der erste Schaltkreis ist hierbei beispielsweise ein Teil einer Leistungselektronik des Elektromotors oder ist mit dieser signaltechnisch gekoppelt. Der erste Schaltkreis ist hierzu zum Beispiel an einen Zwischenkreis als Spannungsversorgung angeschlossen und weist somit eine vergleichsweise hohe Betriebsspannung auf. Unter einer hohen Betriebsspannung ist hierbei insbesondere ein Spannungspotential zu verstehen, das sich in einem für einen Benutzer gefährlichen Spannungsbereich befindet (Hochvolt-Spannung).

Der zweite Schaltkreis ist in einer Anwendung vorzugsweise mit einer Auswerteelektronik des Elektromotors gekoppelt und weist eine vergleichsweise niedrige Betriebsspannung auf, insbesondere in einem Spannungsbereich, der für einen Benutzer möglichst ungefährlich ist (Niedervolt-Spannung). Im zweiten Schaltkreis ist beispielsweise ein Controller angeordnet, mit welchem der Betrieb des Elektromotors steuerbar und/oder regelbar ist. Durch die galvanische Trennung zwischen dem ersten und dem zweiten Schaltkreis ist der Controller sicher vor einer zu hohen Betriebsspannung geschützt. Dadurch ist es möglich, einen vergleichsweise kostengünstigen Controller für die Steuerung und/oder Regelung des Motorbetriebs einzusetzen.

Der Controller ist zumindest im Kern durch einen Mikrocontroller mit einem Prozessor und einem Datenspeicher gebildet, in dem die Funktionalität zur Steuerung und/oder Regelung des Motorbetriebs sowie zur Auslösung einer Sicherheitsfunktion in Form einer Betriebssoftware (Firmware) programmtechnisch implementiert ist, so dass der Elektromotor - gegebenenfalls in Interaktion mit einem Benutzer - bei Ausführung der Betriebssoftware in dem Mikrocontroller automatisch betrieben wird.

Der Controller ist in einer möglichen Ausführungsform im Rahmen der Erfindung alternativ aber auch durch programmierbare elektronische Bauteile, zum Beispiel einen anwendungsspezifischen integrierten Schaltkreis (ASIC) gebildet, in dem die Funktionalität zur Durchführung der Steuerung und/oder Regelung sowie der Sicherheitsfunktion mit schaltungstechnischen Mitteln implementiert ist.

Die galvanische Trennung zwischen dem ersten und dem zweiten Schaltkreis ist insbesondere als eine Schutzisolation ausgeführt, wobei unter einer "sicheren" Übertragung insbesondere eine benutzersichere und zuverlässige Wandlung des hochvoltseitigen Sensorsignals in ein entsprechendes, niedervoltseitiges Sensorsignal einerseits sowie die Übertragung eines für eine Sicherheitsfunktion relevanten Sensorsignals andererseits zu verstehen ist. Als Sicherheitsfunktion ist hierbei insbesondere das sichere elektrische Trennen des Elektromotors vom Zwischenkreis bezeichnet. Das durch das Koppelelement (Optokoppler, Transformator, Kondensator oder dergleichen) übertragene Sensorsignal wird anschließend insbesondere hinsichtlich dieser Sicherheitsfunktion von dem Controller ausgewertet.

Die Sensorelemente sind vorzugsweise gleichartig ausgeführt und zur Überwachung einer physikalischen (Mess-)Größe des Leistungsteils (Länge, Temperatur oder dergleichen) vorgesehen und eingerichtet. Dies bedeutet, dass die Sensorelemente beispielsweise an verschiedenen Positionen der Leistungselektronik angeordnet sind, jedoch die gleiche physikalische Größe erfassen. Vorzugsweise sind die Sensorelemente hierbei im Bereich einer Brückenschaltung der Leistungselektronik angeordnet.

Unter einem resistiven Sensorelement wird insbesondere ein Sensorelement verstanden, welches derart in den ersten Schaltkreis verschaltet ist, dass in Abhängigkeit der jeweiligen Messgröße eine Änderung seines elektrischen Widerstands auftritt. Diese Widerstandsänderung führt zu einem veränderten Spannungsabfall an dem jeweiligen Sensorelement. Dieser Spannungsabfall ist beispielsweise mit einem Spannungsteiler oder einer Brückenschaltung im ersten Schaltkreis erfassbar, wobei ein derartiger erfasster Spannungsabfall im Zuge des Verfahrens insbesondere als das jeweilige Messsignal des Sensorelements zu verstehen ist.

Da vorzugsweise alle Sensorelemente die gleiche Messgröße an der Leistungselektronik überwachen, ist es zur Erkennung eines Fehlerfalls im Zuge einer Sicherheitsfunktion ausreichend, ein einzelnes Sensorsignal zu übermitteln, welches lediglich proportional zu einem der elektrischen Widerstände der Sensorelemente ist, solang dieser Widerstand beziehungsweise das entsprechende Messsignal eine für die Überwachung und Fehlererkennung relevante Information aufweist. Mit anderen Worten wird das Sensorsignal vorzugsweise anhand eines Widerstandwerts bestimmt, welcher von einem Widerstandswert in einem Normalbetrieb (wesentlich) abweicht.

In einer vorteilhaften Weiterbildung ist das Sensorsignal proportional zu dem elektrischen Widerstand des Sensorelements mit dem größten Widerstandswert. In einer möglichen Weiterbildungsform ist insbesondere ein maximaler Widerstandswert als ein Schwellwert für einen Fehler der Leistungselektronik in dem Controller hinterlegt. Im Zuge einer Sicherheitsfunktion, insbesondere für deren Auslösung, wird das Sensorsignal somit hinsichtlich einer Überschreitung des maximalen Widerstandswerts überwacht.

Überschreitet das Sensorsignal den Schwellwert, so wird erkannt, dass ein Fehler der Leistungselektronik vorliegt, wobei in der Folge der Elektromotor sicher abgeschaltet wird. Daher ist es ausreichend, lediglich die Information über das Sensorelement mit dem höchsten Widerstandswert in das Sensorsignal zu kodieren. Dadurch wird die Auswertung des Sensorsignals mittels der niedervoltseitigen Auswerteelektronik wesentlich vereinfacht.

In einer alternativen Weiterbildungsform ist es ebenso denkbar, dass ein minimaler Widerstandswert als unterer Schwellwert vorgegeben wird, wobei das Sensorsignal entsprechend proportional zu dem elektrischen Widerstand des Sensorelements mit dem niedrigsten Widerstandswert ist. Mit der Möglichkeit, sowohl die größten als auch den geringsten Widerstandswert zu übertragen, werden zusätzliche Freiheiten in der Schaltungsauslegung der Schaltkreise erreicht.

In einer geeigneten Ausbildung des Verfahrens werden die Ausgangssignale mittels einer (logischen) UND-Verknüpfung zu dem Sensorsignal kombiniert. Die Ausgangssignale werden anhand eines Vergleichs des jeweiligen Messsignals mit dem Schwingungssignal erzeugt. Dies bedeutet, dass die Ausgangssignale im Wesentlichen eine Periodizität beziehungsweise eine (Wiederholungs-)Frequenz oder Periodendauer aufweisen, welche mit der des Schwingungssignals übereinstimmt. Mit anderen Worten weisen die Ausgangssignale im Wesentlichen alle die gleiche Periodendauer auf, wobei das Tastverhältnis beziehungsweise der Tastgrad (duty factor) der impulsförmigen Ausgangssignale mit dem jeweiligen Messsignal beziehungsweise dem jeweiligen Widerstandswert des Sensorelements variiert. Dies bedeutet, dass die verschiedenen Ausgangssignale zumindest abschnittsweise zeitlich überlappende Signalbereiche aufweisen.

In einer möglichen Ausbildungsform nimmt der Tastgrad des jeweiligen Ausgangssignals mit einem zunehmenden Widerstand des Sensorelements ab. Durch die UND-Verknüpfung wird hierbei sichergestellt, dass lediglich diejenigen Signalbereiche der Ausgangssignale beibehalten werden, die für alle Ausgangssignale zeitlich überlappen. Dies bedeutet, dass das kombinierte Sensorsignal im Wesentlichen identisch zu dem Ausgangssignal mit dem geringsten Tastgrad ist, beziehungsweise dass das Sensorsignal proportional zu dem höchsten Widerstandswert ist. Mit anderen Worten erfolgt mittels der UND-Verknüpfung eine integrierte Maximum- oder Maximalwert-Bildung anhand der Ausgangssignale hinsichtlich der Widerstandswerte der resistiven Sensorelemente.

In einer alternativen Ausbildungsform, in welcher das Sensorsignal dem geringsten Widerstandswert entspricht, werden die Ausgangssignale vorzugsweise mittels einer (logischen) ODER-Verknüpfung miteinander kombiniert. Dadurch ist das Sensorsignal im Wesentlichen identisch zu dem Ausgangssignal mit dem höchsten Tastgrad.

Die erfindungsgemäße Schaltungsanordnung weist zur Durchführung des vorstehend beschriebenen Verfahrens für jedes Sensorelement eine zugeordnete Spannungsteilerschaltung auf, mittels welcher die Widerstandsänderung des Sensorelements im Zuge des Messbetriebs in ein Spannungssignal als Messsignal gewandelt wird. Das impulsförmige Ausgangssignal ist beispielsweise ein pulsweitenmoduliertes (PWM-)Signal, welches mittels eines Komparators anhand des Messsignals des jeweiligen Sensorelements einerseits und des periodischen Schwingungssignals des Signalgenerators andererseits erzeugt wird.

Die Komparatoren sind gemeinsam an einer (ersten) Signalleitung angeschlossen, wobei die Signalleitung das kombinierte Sensorsignal zu dem Koppelelement führt. Dadurch ist eine schaltungstechnisch besonders aufwendungsarme Schaltungsanordnung realisiert. Dies überträgt sich vorteilhaft auf die Herstellungskosten der Schaltungsanordnung sowie einer damit ausgestatteten Motorelektronik. Des Weiteren ist somit eine Schaltungsanordnung realisiert, welche hinsichtlich einer Wartung oder einer Reparatur besonders einfach aufgebaut ist.

In einer zweckmäßigen Ausgestaltung ist das Sensorsignal impulsförmig getaktet, insbesondere ist das Sensorsignal im Wesentlichen ein PWM-Signal. Das Tastverhältnis beziehungsweise der Tastgrad des Sensorsignals ist hierbei proportional zu dem elektrischen Widerstand des Sensorelements mit dem größten Widerstandswert. Durch das impulsförmige Sensorsignal und das Koppelelement ist somit im Wesentlichen eine digitale Isolationsstrecke zwischen dem ersten Schaltkreis und dem zweiten Schaltkreis gebildet. Dadurch ist eine hinsichtlich der Signalqualität besonders geeignete und zuverlässige Übertragung des Sensorsignals von dem ersten Schaltkreis zu dem zweiten Schaltkreis, beziehungsweise von der Leistungselektronik zu der Auswerteelektronik des Elektromotors, realisiert.

In einer bevorzugten Ausführung ist jedes Sensorelement als ein Temperatursensor ausgeführt, der einen elektrischen Widerstand aufweist, dessen Widerstandswert mit der Temperatur der Sensorumgebung, das bedeutet in der Umgebung beziehungsweise dem Detektionsbereich des jeweiligen Sensorelements, variiert.

In einer geeigneten Ausführungsform werden mittels der Sensorelemente beispielsweise die Temperaturen in verschiedenen Bereichen der Leistungselektronik überwacht. Hierzu weist das Sensorelement beispielsweise ein metallisches (ohmsches) Widerstandselement auf, dessen (spezifischer) elektrischer Widerstandswert mit zunehmender Temperatur zunimmt (Kaltleiter, PTC-Widerstand).

Alternativ ist aber ebenso auch der Einsatz eines halbleiterartigen Widerstandselements denkbar, dessen (spezifischer) elektrischer Widerstandswert bei einer zunehmenden Temperatur abnimmt (Heißleiter, NTC-Widerstand).

In einer vorteilhaften Weiterbildung ist der erste Schaltkreis an einen Zwischenkreis eines Elektromotors angeschlossen. Dies bedeutet, dass insbesondere die elektronischen Bauteile der Leistungselektronik von den Sensorelementen überwacht werden, wobei der erste Schaltkreis an den Zwischenkreis als Spannungsquelle angeschlossen ist. Die Sensorelemente sind hierbei beispielsweise baulich fest im Bereich eines mit dem Zwischenkreis gekoppelten (Motor-)Stromrichters, insbesondere im Bereich der Brückenschaltung, zur Überwachung der Betriebstemperatur der elektronischen Bauteile angeordnet.

In einer bevorzugten Ausgestaltung sind die elektronischen Bauteile hierbei insbesondere Brückenmodule der Brückenschaltung. Die Brückenmodule sind beispielsweise als durch die Auswerteschaltung beziehungsweise durch den Controller steuerbare IGBT-Module ausgestaltet, wobei jedem Brückenmodul ein resisitves Sensorelement zur Überwachung dessen Betriebstemperatur zugeordnet ist.

Ein anderer oder weiterer Aspekt der Erfindung sieht vor, dass die Komparatoren zur Erzeugung des Sensorsignals als Schmitt-Trigger in einer Wired-OR-Schaltung (verdrahtetes ODER, Phantom-OR) an die erste Signalleitung angeschlossen sind. Insbesondere sind hierbei sowohl der Ausgang als auch die Mitkopplung des Schmitt-Triggers an die Signalleitung zum Koppelelement angeschlossen. Die beteiligten Komparatorausgänge sind vorzugsweise mittels integrierte Bipolartransistoren als Open-Collector-Ausgänge ausgeführt. Durch die Parallelschaltung der Open-Collector-Ausgänge und der Mitkopplungen aller Schmitt-Trigger ist im Wesentlichen ein UND-Gatter beziehungsweise eine UND-Verknüpfung der Ausgangssignale mittels einer verdrahten Logik gebildet. Dadurch ist eine hinsichtlich des Verschaltungsaufwands besonders einfache und kostengünstige Schaltung zur Generierung des Sensorsignals in der Signalleitung realisiert. Hierbei ist es beispielsweise ebenso denkbar, die Schmitt-Trigger mittels einer Wired-AND-Schaltung an die erste Signalleitung zu koppeln.

In einer geeigneten Ausbildung ist der Signalgenerator ein Dreiecksgenerator, der ein Dreieckssignal beziehungsweise eine Dreiecksspannung als Schwingungssignal erzeugt, welches mittels einer zweiten Signalleitung an die Eingänge der Komparatoren beziehungsweise Schmitt-Trigger geführt ist. Dadurch werden in einfacher Weise die Ausgangssignale, und somit das Sensorsignal, als pulsweitenmodulierte Signale erzeugt.

Die erfindungsgemäße Schaltungsanordnung umfasst in einer konstruktiv vorteilhaften Ausgestaltung einen Optokoppler als Koppelelement, mit welchem der erste Schaltkreis mit dem zweiten Schaltkreis signaltechnisch gekoppelt ist. Durch die Ausgestaltung des Koppelelements als Optokoppler ist zwischen dem ersten und dem zweiten Schaltkreis zusätzlich zu einer galvanischen Trennung eine räumliche Trennung zwischen den Schaltkreisen bereitgestellt, wodurch die Schaltkreise besonders sicher voneinander getrennt sind.

In einer bevorzugten Anwendung wird die Schaltungsanordnung in einem Elektromotor eingesetzt. Der Elektromotor weist hierbei einen in einem Stator drehbar gelagerten Rotor auf, der mittels einer Bestromung von auf den Stator aufgebrachten Statorwicklungen durch ein dadurch generiertes magnetisches Drehfeld in Rotation versetzt wird. Der Elektromotor ist mittels eines Stromrichters (Wechselrichter) an einen Zwischenkreis angeschlossen, wobei der Stromrichter eine Brückenschaltung der Leistungselektronik aufweist.

Die Brückenschaltung umfasst eine der Anzahl der Motorstromphasen entsprechende Anzahl von Brückenmodulen, deren Betriebszustand, insbesondere deren Betriebstemperatur, von jeweils einem resistiven Sensorelement überwacht wird. Das gemeinsame Sensorsignal der Sensorelemente wird mittels des Koppelelements der Schaltungsanordnung von der Hochvolt-Leistungsseite des ersten Schaltkreises der Motorelektronik an eine niedervoltseitige Auswerteelektronik des zweiten Schaltkreises übertragen. Dadurch ist ein hinsichtlich einer Sicherheitsfunktion besonders geeigneter Elektromotor bereitgestellt, welcher insbesondere im Hinblick auf eine Überwachung und sichere Übertragung der Betriebszustände der Brückenmodule während des Motorbetriebs verbessert ist.

Nachfolgend sind Ausführungsbeispiele der Erfindung anhand einer Zeichnung näher erläutert. Darin zeigen:
- Fig. 1: in einer schematischer Blockdarstellung eine Schaltungsanordnung einer Motorelektronik eines Elektromotors, mit einem Stromrichter der mittels resistiven Sensorelementen überwacht wird,
- Fig. 2a bis 2d: in einer schematischen Darstellung Signalverläufe innerhalb der Schaltungsanordnung,
- Fig. 3: in einer schematischen Darstellung einen leistungsseitigen Schaltkreis der Schaltungsanordnung,
- Fig. 4: in einer schematischen Darstellung ein Schaltbild einer Spannungsquelle zur Versorgung des leistungsseitigen Schaltkreises, und
- Fig. 5: in einer schematischen Darstellung ein Ersatzschaldbild von drei Komparatoren mit jeweils einem Open-Collector-Ausgang.

Einander entsprechende Teile und Größen sind in allen Figuren stets mit den gleichen Bezugszeichen versehen.

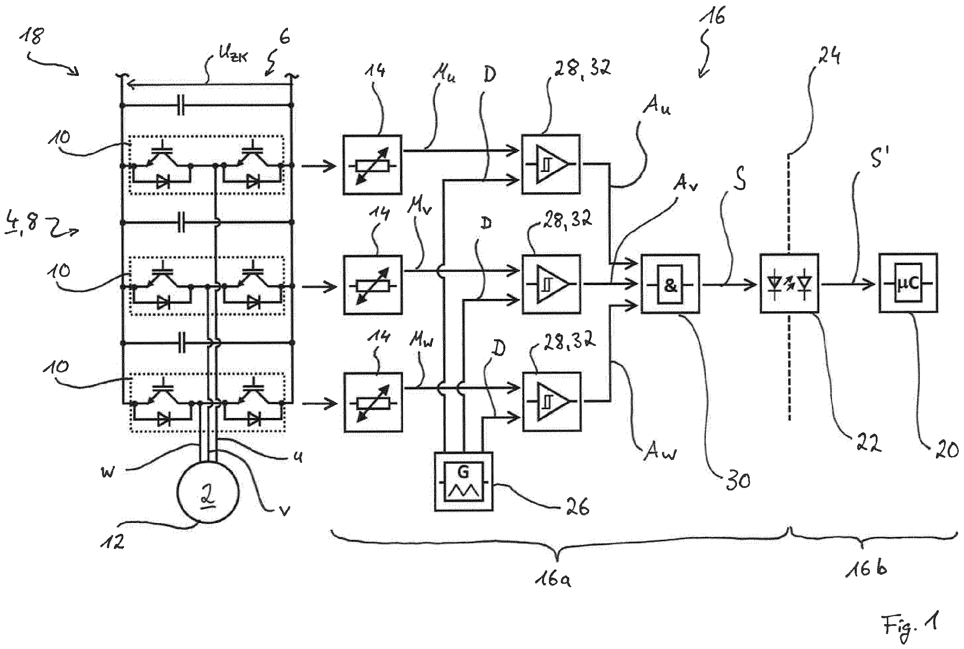

In der Fig. 1 ist ein Elektromotor 2 dargestellt, der mittels eines als Wechselrichter ausgestalteten Stromrichters 4 an einen (Gleichspannungs-)Zwischenkreis 6 angeschlossen ist. Der Stromrichter 4 weist eine Brückenschaltung 8 mit drei Brückenmodulen 10 auf, mit welcher eine Zwischenkreisspannung U_{ZK} des Zwischenkreises 6 in eine dreiphasige Versorgungsspannung mit den Phasen u, v, w für den Betrieb des Elektromotors 2 gewandelt wird. Die Brückenmodule 10 sind hierbei vorzugsweise als gesteuerte IGBT-Module ausgestaltet.

Die Phasen u, v, w sind von der Brückenschaltung 8 an entsprechende Phasen- oder Wicklungsenden einer Statorwicklung 12 eines nicht näher dargestellten Stators des Elektromotors 2 geführt. Im Bereich der Brückenschaltung 8 ist je Phase u, v, w beziehungsweise je Brückenmodul 10 ein resistives Sensorelement 14 einer Schaltungsanordnung 16 vorgesehen. Die Sensorelemente 14 sind als Temperatursensoren ausgebildet und überwachen im Betrieb die Brückenmodule 10 beziehungsweise deren IGBT-Transistoren hinsichtlich einer Überhitzung, wie sie beispielsweise im Zuge eines Überstroms oder eines Fehlers (zum Beispiel ein Versagen oder ein Ausfall eines Lüfters eines Kühlkörpers der Leistungshalbleiter der Brückenmodule 10) auftritt.

Die Schaltungsanordnung 16 ist Teil einer Motorelektronik 18 des Elektromotors 2, und ist vorzugsweise an den mit dem Stromrichter 4 gekoppelten Zwischenkreis 6 angeschlossen, welcher zumindest einen ersten Schaltkreis 16a der Schaltungsanordnung 16 mit der Betriebs- oder Zwischenkreisspannung U_{ZK} versorgt. Die Motorelektronik 18 umfasst im Wesentlichen eine hochvoltseitige Leistungselektronik mit dem Stromrichter 4 und dem Schaltkreis 16a sowie eine niedervoltseitige Auswerteelektronik welche im Wesentlichen durch einen zweiten Schaltkreis 16b der Schaltungsanordnung 16 gebildet ist.

Die Zwischenkreisspannung U_{ZK} weist ein vergleichsweise hohes Spannungspotential auf. Zur Steuerung und Regelung des Elektromotors 2 ist ein Controller 20 als Motorsteuerung vorgesehen. Der beispielsweise als Mikrocontroller ausgebildete Controller 20 ist hierbei in dem Schaltkreis 16b der Schaltungsanordnung 16 angeordnet, welcher eine vergleichsweise niedrige Betriebsspannung aufweist. Die Schaltkreise 16a und 16b sind mittels eines als Schutzisolation ausgeführten Koppelelements 22 an einer Isolationsgrenze 24 voneinander galvanisch getrennt.

Im Betrieb generieren die Sensorelemente 14 jeweils ein der Betriebstemperatur der Brückenmodule 10 der Phasen u, v, w entsprechendes Messsignal Mᵤ, Mᵥ, M_{w}. Die Messsignale Mᵤ, Mᵥ, M_{w} werden für jedes Sensorelement 14 mit einem für alle Sensorelemente 14 gemeinsamen Schwingungssignal D verglichen. Das Schwingungssignal D ist ein von einem Signalgenerator 26 generiertes Dreiecksignal beziehungsweise eine Dreieckspannung, welche zusammen mit dem jeweiligen Messsignal Mᵤ, Mᵥ, M_{w} an die Eingänge eines Komparators 28 geführt ist.

An den Ausgängen der Komparatoren 28 entsteht jeweils ein periodisches Ausgangssignal Aᵤ, Aᵥ, A_{w} mit der Frequenz der Dreieckspannung D. Insbesondere weisen die Ausgangssignale Aᵤ, Aᵥ und A_{w} eine mit der Dreiecksspannung D gemeinsame Periodendauer T auf. Die impulsförmigen Ausgangssignale Aᵤ, Aᵥ, A_{w} weisen hierbei einen Tastgrad oder ein Tastverhältnis auf, welches proportional zu dem Messsignal Mᵤ, Mᵥ, M_{w} beziehungsweise zu dem Widerstandswert eines (Mess-)Widerstands Rᵤ, Rᵥ, R_{w} des jeweiligen resistiven Sensorelements 14 ist. Die Widerstände Rᵤ, Rᵥ, R_{w} der Sensorelemente 14 sind beispielsweise als metallische (ohmsche) Widerstandelemente ausgeführt, deren (spezifischer) elektrischer Widerstand beziehungsweise deren Widerstandswert bei einer Erhöhung der Umgebungs- oder Sensortemperatur zunimmt.

Die Ausgangssignale Aᵤ, Aᵥ und A_{w} der einzelnen Komparatoren 28 werden über eine logische Verknüpfung 30 zu einem Sensorsignal S zusammengefasst beziehungsweise kombiniert. In dem Ausführungsbeispiel der Fig. 1 wird bei einer Erhöhung des Widerstandswerts der Widerstände Rᵤ, Rᵥ, R_{w} des jeweiligen Sensorelements 14 das Spannungsniveau des jeweiligen Messsignals Mᵤ, Mᵥ, M_{w} erhöht, wodurch die entsprechenden Ausgangssignale Aᵤ, Aᵥ und A_{w} einen verringerten Tastgrad aufweisen. Mit anderen Worten bewirkt eine Temperaturänderung im Detektionsbereich der Sensorelemente 14 eine Verlängerung oder Verkürzung der Pulsbreiten oder Pulsdauern T der rechteckförmigen Ausgangssignale Aᵤ, Aᵥ und A_{w}. Dies bedeutet, dass das Ausgangssignal Aᵤ, Aᵥ und A_{w} mit der geringsten Pulsbreite T demjenigen Sensorelement 14 entspricht, dessen Widerstand Rᵤ, Rᵥ, R_{w} den höchsten Widerstandswert aufweist.

Die Verknüpfung 30 ist in dem dargestellten Ausführungsbeispiel insbesondere als eine UND-Verknüpfung ausgeführt, das bedeutet, dass der Tastgrad oder das Tastverhältnis des Sensorsignals S dem Widerstandswert des Sensorelements 14 mit dem größten Widerstandswert beziehungsweise dem Ausgangssignal Aᵤ, Aᵥ und A_{w} mit der geringsten Pulsbreite T entspricht. Das Sensorsignal S wird anschließend mittels des als Optokoppler ausgeführten Koppelelements 22 von dem hochvoltseitigen Schaltkreis 16a an den niedervoltseitigen Schaltkreis 16b übertragen. Durch den Optokoppler 22 wird das Sensorsignal S in ein Sensorsignal S' gewandelt, welches hinsichtlich des Tastgrads beziehungsweise des Tastverhältnisses im Wesentlichen identisch zu dem Sensorsignal S ist, wobei das Sensorsignal S' jedoch galvanisch von der Zwischenkreisspannung U_{ZK} getrennt ist. Das Sensorsignal S' wird anschließend zum Controller 20 geführt.

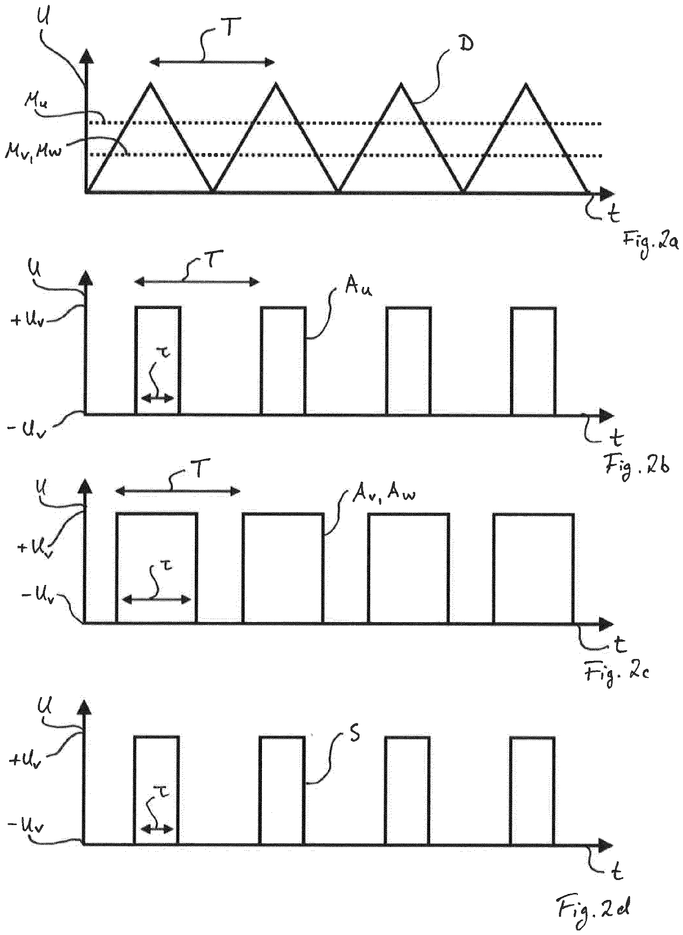

In den Figuren 2a bis 2d sind beispielhafte Signalverläufe für die Dreieckspannung D (Fig. 2a) und die Ausgangssignale Aᵤ, Aᵥ und A_{w} (Fig. 2b und Fig. 2c) sowie das daraus anhand der UND-Verknüpfung 30 erzeugte Sensorsignal S gezeigt. Die schematisierten Signalverläufe sind hierbei entlang einer gemeinsamen Abszissenachse als Zeitachse t und einer jeweiligen Ordinatenachse als Spannungsachse U aufgetragen.

Das dargestellte Ausführungsbeispiel der Figuren 2a bis 2d zeigt den Fall, dass das Brückenmodul 10 der Phase u eine erhöhte Betriebstemperatur gegenüber den Brückenmodulen 10 der Phasen v und w aufweist. Dadurch weist der Widerstand Rᵤ des Sensorelements 4 einen erhöhten Widerstandswert auf, wodurch auch der Spannungspegel des Messsignals Mᵤ gegenüber den Messsignalen Mᵥ und M_{w} der Phasen v und w erhöht ist, wobei die Messsignale Mᵥ und M_{w} in diesem Ausführungsbeispiel einen im Wesentlichen identischen Spannungspegel aufweisen. In der Fig. 2a sind die Spannungspegel oder -niveaus der Messsignale Mᵤ, Mᵥ und M_{w} als gestrichelte Linien mit der Dreieckspannung D dargestellt.

Die Dreieckspannung D einerseits und das jeweilige Messsignal Mᵤ, Mᵥ, M_{w} andererseits sind an die Eingänge des jeweils zugeordneten Komparators 28 geführt. Der Komparator 28 ist insbesondere nach Art eines Schmitt-Triggers 32 in den Schaltkreis 16a verschaltet, sodass die daraus generierten Ausgangssignale Aᵤ, Aᵥ und A_{w} - wie in den Figuren 2b und 2c dargestellt - unterschiedliche Tastgrade aufweisen. Insbesondere weist das Ausgangssignal Aᵤ der Phase u einen gegenüber den Ausgangssignalen Aᵥ und A_{w} reduzierten Tastgrad, das bedeutet eine reduzierte oder verkürzte Pulsbreite T, auf. Mit anderen Worten werden die Ausgangssignale Aᵤ, Aᵥ und A_{w} anhand der Widerstandswerte der (Sensor-)Widerstände Rᵤ, Rᵥ und R_{w} mit dem Schmitt-Trigger 32 pulsweitenmoduliert. Die Amplitude der Ausgangssignale Aᵤ, Aᵥ und A_{w} ist hierbei durch die Versorgungsspannung Uᵥ des Komparators 28 definiert, wobei die Signalpegel zwischen einem oberen AN-Niveau (+Uᵥ) und einem unteren AUS-Niveau (-Uᵥ) geschaltet wird. Die Versorgungsspannung Uᵥ ist beispielsweise anhand der Zwischenkreisspannung U_{ZK} erzeugt.

Wie in einer zusammenschauenden Betrachtung der Fig. 2b mit der Fig. 2c vergleichsweise deutlich ersichtlich ist, weisen die pulsweitenmodulierten Ausgangssignale Ausgangssignale Aᵤ, Aᵥ und A_{w} zeitlich überlappende Signalbereiche auf. Durch die UND-Verknüpfung 30 werden hierbei lediglich diejenigen Signalbereiche auf einem hohen Spannungsniveau (+Uᵥ) beibehalten, bei welchen alle drei Ausgangssignale Aᵤ, Aᵥ und A_{w} das hohe Spannungsniveau (+Uᵥ) aufweisen beziehungsweise einen gemeinsamen Überlappungsbereich aufweisen, die restlichen Signalbereiche werden auf das niedrige Spannungsniveau (-Uᵥ) gesetzt. Dadurch weist das durch die UND-Verknüpfung 30 generierte Sensorsignal S in Fig. 2d im Wesentlichen den identischen Signalverlauf zu dem Ausgangssignal Aᵤ in der Fig. 2b auf. Mit anderen Worten erfolgt mittels der UND-Verknüpfung 30 eine Maximalwert-Bildung hinsichtlich der Widerstandswerte der Widerstände Rᵤ, Rᵥ und R_{w}, wobei sich in diesem Ausführungsbeispiel lediglich das Ausgangssignal Aᵤ als das Sensorsignal S durchsetzt.

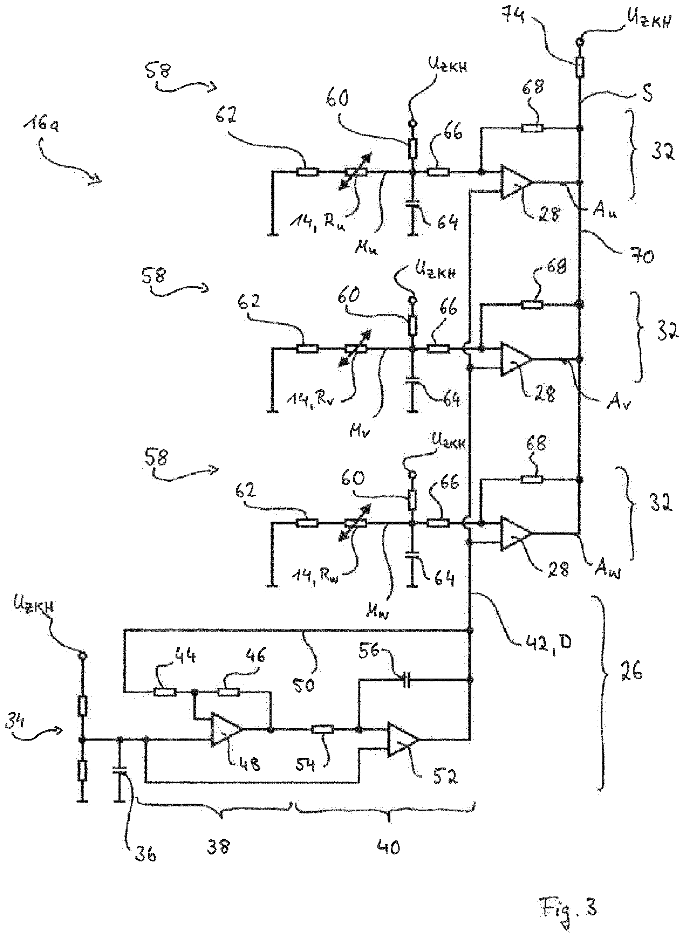

In der Fig. 3 ist eine mögliche Ausgestaltung des hochvoltseitigen Schaltkreises 16a dargestellt und nachfolgend näher erläutert.

Der Dreieckgenerator 26 ist mittels eines Spannungsteilers 34 und eines nachgeschalteten Kondensators 36 zur Spannungsstabilisierung an die Zwischenkreisspannung U_{ZK} angeschlossen. Hierzu ist der Spannungsteiler 34 beispielsweise mit einem Minuspfad des Zwischenkreises 6 verschaltet. Der Dreieckgenerator 26 wird mit der Zwischenkreisspannung U_{ZK} im Single-Supply Betrieb versorgt und stellt mittels einer Reihenschaltung eines nicht invertierten Schmitt-Triggers 38 und eines Integrators 40 an einer Signalleitung 42 das Dreiecksignal D bereit. Der Schmitt-Trigger 38 und der Integrator 40 sind hierbei in Reihe geschaltet, das bedeutet, dass der Ausgang des Schmitt-Triggers 38 mit einem Eingang des Integrators 40 verbunden ist, wobei der Ausgang des Integrators 40 an die Signalleitung 42 angeschlossen ist. Der Schmitt-Trigger 38 weist funktionsgemäß zwei ohmsche Widerstände 44 und 46 sowie einen Komparator 48 auf. Durch die Widerstandswerte der Widerstände 44 und 46 sind die Schaltgrenzen beziehungsweise die Hysterese des Schmitt-Triggers 38 definiert. Der Komparator 48 ist an den Spannungsteiler 34 einerseits und mit einer Rückkopplung 50 an die Signalleitung 42 andererseits angeschlossen.

Der Integrator 40 weist einen Komparator 52 und einen zwischen dem Komparator 52 und dem Schmitt-Trigger 38 verschalteten Ladewiderstand 54 sowie einen parallel zum Komparator 52 und mit dessen Ausgang und Eingang gekoppelten Ladekondensator 56 auf. Der zweite Eingang des Integrators 40 ist hierbei mit dem Spannungsteiler 34 gekoppelt. Aus dem rückgekoppelten Dreiecksignal D vom Ausgang des Integrators 40 zum nicht invertierten Eingang des Schmitt-Triggers 38 wird eine Rechteckspannung generiert, die durch den Integrator 40 in das Dreiecksignal D gewandelt wird.

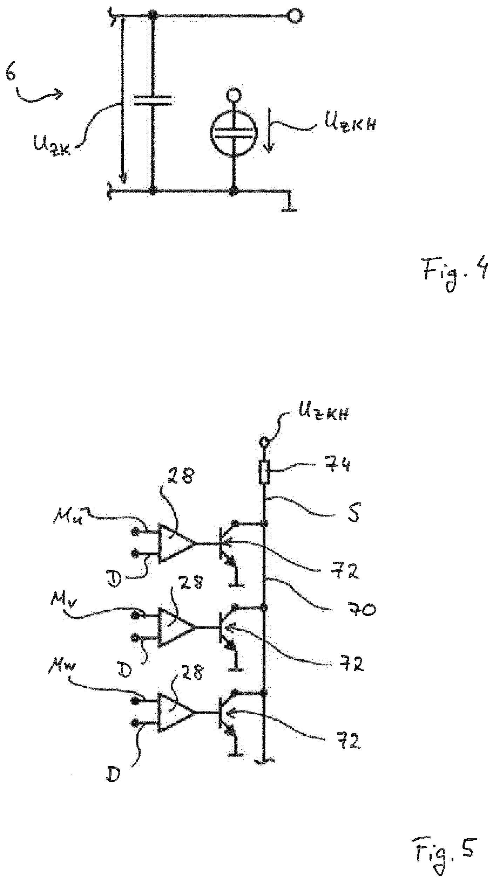

Die Sensorelemente 14 sind mittels ihres elektrischen (Mess-)Widerstandes Rᵤ, Rᵥ, R_{w} in einer jeweiligen Spannungsteilerschaltung 58 an die Zwischenkreisspannung U_{ZK} gekoppelt. Die Spannungsteilerschaltung 58 ist einerseits an eine Versorgungsspannung U_{ZKH} angeschlossen, deren Bezugspotential - wie in der Fig. 4 dargestellt - die Zwischenkreisspannung U_{ZK} ist und andererseits gegen Masse geschaltet. Die Spannungsteilerschaltung 58 umfasst in einer Reihenschaltung einen ersten Widerstand 60 und den jeweiligen (Mess-)Widerstand Rᵤ, Rᵥ, R_{w} des Sensorelements 14 sowie einen zweiten Widerstand 62. Zwischen den Widerstand 60 und dem Widerstand Rᵤ, Rᵥ, R_{w} wird eine Spannung als Messsignal Mᵤ, Mᵥ, M_{w} abgegriffen und an den Eingang des jeweiligen Schmitt-Triggers 32 geführt. Zwischen dem Schmitt-Trigger 32 und der Spannungsteilerschaltung 58 ist jeweils ein Kondensator 64 zur Stabilisierung des Messsignals Mᵤ, Mᵥ, M_{w} gegen Masse geschaltet.

Der Komparator 28 des Schmitt-Triggers 32 ist hierbei einerseits an den Abgreifpunkt der jeweiligen Spannungsteilerschaltung 58 und andererseits an die Signalleitung 42 angeschlossen. Der Schmitt-Trigger 32 weist zwei Widerstände 66 und 68 zur Bildung der Schalt-Hysterese auf, wobei der Widerstand 66 zwischen dem Komparator 28 und der Spannungsteilerschaltung 58 und der Widerstand 68 mit der Mitkopplung an den Ausgang des Komparators 28 geschaltet ist.

Die Ausgänge der Komparatoren 28 sind an eine gemeinsame Signalleitung 70 angeschlossen. Dies bedeutet, dass die Rückkopplungen der Schmitt-Trigger 32 mit der Signalleitung 70 verbunden sind. Wie in dem vereinfachten Ersatzschaltbild der Fig. 5 dargestellt, weisen die Ausgänge der Komparatoren 28 hierbei integrierte Transistoren 72 auf. Die Transistoren 72 sind vorzugsweise als Bipolar-Transistoren ausgeführt, und sind jeweils als ein Open-Collector-Ausgang des Komparators 28 an die Signalleitung 70 angeschlossen. Durch die integrierten Transistoren 72 sind die Schmitt-Trigger 32 in einer Wired-OR-Schaltung (verdrahtetes ODER, Phantom-OR) an die Signalleitung 70 angebunden. Dadurch ist effektiv die logische UND-Verknüpfung 30 realisiert, wodurch das kombinierte Sensorsignal S in der Signalleitung 70 generiert wird. Das Sensorsignal S wird vorzugsweise an einem Widerstand 74 abgegriffen und zu dem Optokoppler 22 geführt.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

So ist es beispielsweise denkbar, ein Sensorsignal S zu generieren, welches dem Ausgangssignal Aᵤ, Aᵥ, A_{w} desjenigen Widerstands Rᵤ, Rᵥ, R_{w} der Sensorelemente 14 entspricht, welcher den geringsten Widerstandswert aufweist. Hierzu wird beispielsweise anstatt einer UND-Verknüpfung eine ODER-Verknüpfung zur Kombination der Ausgangssignale Aᵤ, Aᵥ, A_{w} verwendet.

Alternativ ist es ebenso denkbar, die Reihenfolge der Widerstände 60 und der Widerstände Rᵤ, Rᵥ, R_{w} in den Spannungsteilerschaltungen 58 zu vertauschen. Dadurch werden bei einer Erhöhung der Widerstandswerte der Widerstände Rᵤ, Rᵥ, R_{w} das Spannungsniveau der Messsignale Mᵤ, Mᵥ, M_{w} reduziert.

Ebenso denkbar ist es beispielsweise auch Widerstandselemente Rᵤ, Rᵥ, R_{w} zu verwenden, deren (spezifischer) elektrischer Widerstand bei einer Temperaturerhöhung reduziert wird.

### Bezugszeichenliste

- 2: Elektromotor
- 4: Stromrichter
- 6: Zwischenkreis
- 8: Brückenschaltung
- 10: Brückenmodul
- 12: Statorwicklung
- 14: Sensorelement
- 16: Schaltungsanordnung
- 16a, 16b: Schaltkreis
- 18: Motorelektronik
- 20: Controller
- 22: Koppelelement/Optokoppler
- 24: Isolationsgrenze
- 26: Signalgenerator/Dreieckgenerator
- 28: Komparator
- 30: UND-Verknüpfung
- 32: Schmitt-Trigger
- 34: Spannungsteiler
- 36: Kondensator
- 38: Schmitt-Trigger
- 40: Integrator
- 42: Signalleitung
- 44,46: Widerstand
- 48: Komparator
- 50: Rückkopplung
- 52: Komparator
- 54: Ladewiderstand
- 56: Ladekondensator
- 58: Spannungsteilerschaltung
- 60,62: Widerstand
- 64: Kondensator
- 66,68: Widerstand
- 70: Signalleitung
- 72: Transistor
- 74: Widerstand

- u, v, w: Phase
- Mᵤ, Mᵥ, M_{w}: Messsignal
- Aᵤ, Aᵥ, A_{w}: Ausgangssignal
- U_{ZK}: Betriebsspannung/Zwischenkreisspannung
- D: Schwingungssignal/Dreieckspannung
- Rᵤ, Rᵥ, R_{w}: Widerstand
- S, S': Sensorsignal
- T: Periodendauer
- T: Pulsdauer/Pulsbreite
- t: Zeit
- U: Spannung
- Uᵥ: Versorgungsspannung
- U_{ZKH}: Versorgungsspannung

## Patentansprüche

1. Verfahren zur sicheren Übertragung eines Sensorsignals (S) einer Anzahl von resistiven Sensorelementen (14) von einem ersten Schaltkreis (16a) auf einem vergleichsweise hohen Spannungspotential (U_{ZK}) zu einem galvanisch getrennten zweiten Schaltkreis (16b) auf einem vergleichsweise niedrigen Spannungspotential mittels eines Koppelelements (22),
- wobei die Sensorelemente (14) jeweils ein Messsignal (Mᵤ, Mᵥ, M_{w}) generieren, das mit einem von einem Signalgenerator (26) erzeugten periodischen Schwingungssignal (D) verglichen wird,
- wobei anhand des Ergebnisses des Vergleichs jeweils ein Ausgangssignal (Aᵤ, Aᵥ, A_{w}) generiert wird, und
- wobei die Ausgangssignale (Aᵤ, Aᵥ, A_{w}) zu einem Sensorsignal (S) kombiniert werden, welches proportional zu einem elektrischen Widerstand (Rᵤ, Rᵥ, R_{w}) eines der Sensorelemente (14) ist.

2. Verfahren nach Anspruch 1,
**dadurch gekennzeichnet,**
**dass** das Sensorsignal (S) proportional zu dem elektrischen Widerstand (Rᵤ, Rᵥ, R_{w}) des Sensorelements (14) mit dem größten Widerstandswert ist.

3. Verfahren nach Anspruch 1 oder 2,
**dadurch gekennzeichnet,**
**dass** die Ausgangssignale (Aᵤ, Aᵥ, A_{w}) mittels einer UND-Verknüpfung (30) zu dem Sensorsignal (S) kombiniert werden.

4. Schaltungsanordnung (16) zur Durchführung des Verfahrens nach einem der Ansprüche 1 bis 3,
**dadurch gekennzeichnet,**
- **dass** die Sensorelemente (14) jeweils in einer Spannungsteilerschaltung (58) zur Erzeugung des Messsignals (Mᵤ, Mᵥ, M_{w}) verschaltet sind,
- **dass** jeweils ein Komparator (28) das Messsignal (Mᵤ, Mᵥ, M_{w}) des zugeordneten Sensorelements (14) mit dem periodischen Schwingungssignal (D) des Signalgenerators (16) vergleicht und ein impulsförmiges Ausganssignal (Aᵤ, Aᵥ, A_{w}), insbesondere ein PWM-Signal, erzeugt, und
- **dass** die Komparatoren (28) an das Koppelelement (22) mittels einer ersten Signalleitung (70) angeschlossen sind, die das Sensorsignal (S) führt.

5. Schaltungsanordnung (16) nach Anspruch 4,
**dadurch gekennzeichnet,**
**dass** das Sensorsignal (S) impulsförmig getaktet ist, wobei dessen Tastverhältnis (T/T) proportional zu dem elektrischen Widerstand (Rᵤ, Rᵥ, R_{w}) des Sensorelements (14) mit dem größten Widerstandswert ist.

6. Schaltungsanordnung (16) nach Anspruch 4 oder 5,
**dadurch gekennzeichnet,**
**dass** jedes Sensorelement (14) ein Temperatursensor ist, der einen elektrischen Widerstand (Rᵤ, Rᵥ, R_{w}) aufweist, dessen Widerstandswert mit der Temperatur der Sensorumgebung variiert.

7. Schaltungsanordnung (16) nach einem der Ansprüche 4 bis 6,
**dadurch gekennzeichnet,**
**dass** der erste Schaltkreis (16a) an einen Zwischenkreis (6) eines Elektromotors (2) angeschlossen ist.

8. Schaltungsanordnung (16) nach Anspruch 7,
**dadurch gekennzeichnet,**
**dass** jeweils ein Sensorelement (14) in einer Wirkverbindung mit einem Brückenmodul (10) des Elektromotors (2) ist.

9. Schaltungsanordnung (16) nach einem der Ansprüche 4 bis 8,
**dadurch gekennzeichnet,**
**dass** die Komparatoren (28) zur Erzeugung des Sensorsignals (S) als Schmitt-Trigger (32) in einer Wired-OR-Schaltung an die erste Signalleitung (70) angeschlossen sind.

10. Schaltungsanordnung (16) nach einem der Ansprüche 4 bis 9,
**dadurch gekennzeichnet,**
**dass** der Signalgenerator (26) ein Dreiecksgenerator ist, der ein Dreieckssignal als Schwingungssignal (D) erzeugt, welches mittels einer zweiten Signalleitung (42) an die Eingänge der Komparatoren (28) geführt ist.

11. Schaltungsanordnung (16) nach einem der Ansprüche 4 bis 10,
**dadurch gekennzeichnet,**
**dass** das Koppelelement (22) als ein Optokoppler zur signaltechnischen Kopplung des ersten Schaltkreises (16a) mit dem zweiten Schaltkreis (16b) ausgeführt ist.

12. Elektromotor (2) mit einem in einem Stator drehbar gelagerten Rotor und mit einem Stromrichter (4) zur Erzeugung eines Drehfeldes mit einer Anzahl von Brückenmodulen (10), wobei jedem Brückenmodul (10) ein resistives Sensorelement (14) zugeordnet ist, und mit einer Schaltungsanordnung (16) nach einem der Ansprüche 4 bis 11.
